# EUROPEAN PATENT SPECIFICATION

(11) **EP 2 928 763 B1**
(45) Date of publication and mention of the grant of the patent: **18.07.2018**
(21) Application number: 13859898.2
(22) Date of filing: 20.11.2013
(51) Int. Cl.: B62D 67/00, B60R 16/02, H05K 5/02

(54) **DEVICE AND METHOD FOR MAKING A MEMORY DEVICE AT A CONTROL UNIT OF A MOTOR VEHICLE UNUSABLE**
VORRICHTUNG UND VERFAHREN ZUR UNBENUTZBARMACHUNG EINER SPEICHERVORRICHTUNG AN EINER STEUEREINHEIT EINES KRAFTFAHRZEUGES
DISPOSITIF ET PROCÉDÉ DESTINÉS À RENDRE INUTILISABLE UN DISPOSITIF DE MÉMOIRE AU NIVEAU D'UNE UNITÉ DE COMMANDE D'UN VÉHICULE À MOTEUR

(30) Priority: 05.12.2012 SE 1251374
(43) Date of publication of application: 14.10.2015
(73) Proprietor: Scania CV AB, 151 87 Södertälje (SE)
(72) Inventor: SCHLÜTER, Ortwin, S-153 95 Järna (SE); BACKMAN, Rasmus, S-152 51 Södertälje (SE)
(74) Representative: Scania CV AB
(86) International application number: PCT/SE2013/051369
(87) International publication number: WO 2014/088489

(56) References cited:
- JP-A- 2003 217 357
- JP-A- 2006 007 206
- JP-A- 2006 007 206
- US-A1- 2006 118 326
- US-A1- 2008 250 948
- US-A1- 2008 250 948

## Description

### FIELD OF THE INVENTION

The invention relates to a device pertaining to a control unit for a motor vehicle, comprising a housing for a carrier substrate on which a memory device is situated. The invention relates also to a control unit and to a method for making a device as above.

### STATE OF THE ART

In today's utility vehicles, e.g. trucks and buses, the majority of internal functions for various vehicle components are conducted by one of more electronic control units. In general, control systems of modern vehicles usually comprise a communication bus system consisting of one or more communication buses for connecting a number of electronic control units (ECUs) to the various components on board the vehicle which are to be controlled or from which sensor or parameter signals are to be conveyed.

Such a control system may thus comprise a plurality of control units, and taking care of a specific function may be divided between two or more of them.

The main component of a control unit is a so-called microcontroller which in addition to calculation circuits comprises not only programmed-in software but also application data in a memory device.

To make it difficult to "reverse-engineer" software and other control unit content which is highly concentrated within the memory device, it is usual to physically destroy the control unit before disposal. This also prevents unauthorised use of the control unit, e.g. on vehicles for which it is not intended and on which installing it might lead to serious malfunctions and even breakdowns.

The destruction of the control unit is normally achieved by the microcontroller being taken out and destroyed so that its memory circuits become unusable and unreadable.

US2008250948 discloses a method and device for destruction of a hard disk, the device having a penetration point that is manually pressed against the disk.

JP2006007206 discloses a recording medium destruction device. During destruction, troughs are punched in the recording medium and current is allowed to flow through the medium.

### OBJECT AND MOST IMPORTANT CHARACTERISTICS OF THE INVENTION

An object of the present invention is to propose a device of the kind mentioned in the introduction which represents an improvement on previous known devices as regards their handling.

This object is achieved according to the invention by the housing being provided with an externally visible position marking which indicates a location for the memory device within the housing, and with, in the area of the position marking, at least one guide for a perforating tool which, when placed according to the position marking and directed by said at least one guide, can be used to render the memory device unusable.

Thus the memory device itself becomes locatable from outside and means are also provided on the actual housing for aligning and guiding a perforating tool to ensure that upon completion of perforation the memory device really will have been rendered unusable.

It is to be understood from the foregoing that the object of the invention is to make it impossible to read and use the control unit's programme memory and data memory, herein called "memory device". This memory device is normally so co-located with a calculation unit which performs calculations, sends control signals etc., as to constitute a microcontroller, but without excluding the possibility that the memory device might be located away from such a calculation unit.

The position marking leads an operator directly to the location where the perforating tool is to be applied, and said guide or guides for the perforating tool result in the tool not straying during drilling of the housing, particularly at the beginning of the perforating process when the tool is applied to the surface of the housing and the tool rotation is initiated. Thus the perforating tool will make the hole at the right location and in the right direction without straying and really will penetrate the memory device.

"Straying" means the tool, when applied to a (planar) surface, failing to begin immediately to work purely axially but instead moving a greater or smaller distance sideways before it can finally begin to create a hole.

It is important that the tool's guidance be assured to make it unnecessary to use special tools and make it possible to use ordinary drills or the like which typically have a forward edge which tends to stray in a largely linear or slightly curving way, and thus lack a needle-like concentrated tip.

The memory device does in fact occupy a relatively small surface on the carrier substrate and is usually situated at such a distance from a wall of the housing which is to be penetrated by the perforating tool that the tool straying even relatively slightly sideways at the beginning of a perforating process without said guide or guides might well lead to the target being missed and the memory device remaining intact, leading to potential problems as above.

The feature that "in the area of the position marking the housing is provided with at least one guide for a perforating tool" means that the guide is at a location indicated by the position marking even if the marking is for example an arrow situated a certain distance away from that location.

It is also easy, with a device according to the invention, to verify, normally from outside the housing, that the control unit really has been rendered unusable, by visual inspection or by using a detecting pin or the like to verify that the hole has been drilled deep enough and has therefore passed through a location for the memory device.

Said position marking preferably takes the form of one or more of the following: colour marking(s) on a surface of the housing, surface structure marking(s) on a surface of the housing, depression(s) in a surface of the housing, elevation(s) on a surface of the housing. A surface structure marking may take the form of visible grooving, ridging or the like. A depression or an elevation may be given any desired shape, e.g. an arrow, a cross, a star or an enclosing marking in the form of a circle, an oval, a polygon or the like. A position marking may be at the actual location where the perforating tool is to be applied or take the form of an arrow, line or the like situated at a distance from, but pointing the operator towards, that location.

Said at least one guide takes the form of one or more of the following: a depression in a surface of the housing, one or more guiding elevations on a surface of the housing, a layer of flexible material attached to a surface of the housing. A depression may be a concavity or indentation in a surface of the housing or the like.

Both a depression and a guiding elevation may be created in the process of forming the housing element as a result of modifications in a moulding element. A guiding elevation may take the form of an annular ridge or a number of protrusions surrounding a perforable location. It may also be placed on the housing after the making of the latter has otherwise been completed.

A layer of flexible material may be a thick tape, a layer of plastic or foam, a thick layer of paint or the like. The layer may itself, but need not, exhibit the position marking. In such cases the position marking may be outside the area covered by the flexible material.

Applying the tool to the flexible material achieves a guiding effect which prevents the tip of the tool from straying as above. The flexible material may also have a clear surface, preferably centrally, where perforation is to take place.

It is also possible for said guide to be situated between adjacent flange protrusions on the housing, typically supplemented by transverse ridges between the protrusions.

It may be possible and sometimes appropriate that said position marking and said guide are co-located, in which case they may wholly or partly be parts of the same element. For example, a ridgelike and annular guide may be so made, e.g. be rendered conspicuous by a contrasting colour, that it can serve as the position marking.

The housing is with advantage made of at least one of the following materials: a plastic material, a composite material including plastic, a metal, a metal alloy. It is of course possible for part of the housing to be made from one material and another part from another material.

The invention relates also to a control unit for a motor vehicle comprising a carrier substrate on which a memory device as above is situated, which control unit comprises a device according to the invention. Control unit means here the complete control device with memory device on a carrier substrate enclosed in a housing.

The invention relates also to a method for making a device pertaining to a control unit for a motor vehicle, which control unit comprises a housing for a carrier substrate on which a memory device is situated.

The method is distinguished in that a location in line with the memory device on the carrier substrate is indicated by the fact that a position marking is provided on a surface of a housing which accommodates said carrier substrate, and that in the area of the position marking the housing is provided with at least one guide for a perforating tool.

The position marking takes with advantage the form of one or more of the following: colour marking(s) on a surface of the housing, surface structure marking(s) on a surface of the housing, depression(s) in a surface of the housing, elevation(s) on a surface of the housing.

The position marking and/or said at least one guide may with advantage be created by a modification in a moulding element/housing-forming component provided with a corresponding protrusion or recess.

### BRIEF DESCRIPTION OF DRAWINGS

The invention will now be described in more detail on the basis of embodiment examples with reference to the attached drawings, in which
Fig. 1a depicts close to a utility vehicle a control unit equipped with a device according to the invention in plan view,
Figs. 1b and 1c depict alternative devices according to the invention,
Fig. 2 depicts a control unit equipped according to the invention in the process of being rendered unusable,
Fig. 3 is a simple flowchart of a sequence of a method according to the invention, and
Figs. 4a, b, c and d depict various guides for a perforating tool.

### DESCRIPTION OF EMBODIMENT EXAMPLE

Microcontroller in this specification means a calculation unit which not only is the calculating and preprogrammed unit in a control unit for a motor vehicle but also has a memory device which comprises both programme memory and data memory. Drilling through such a microcontroller results also in drilling through the memory device, so in practice it is normally the position of the microcontroller that has to be localised and indicated.

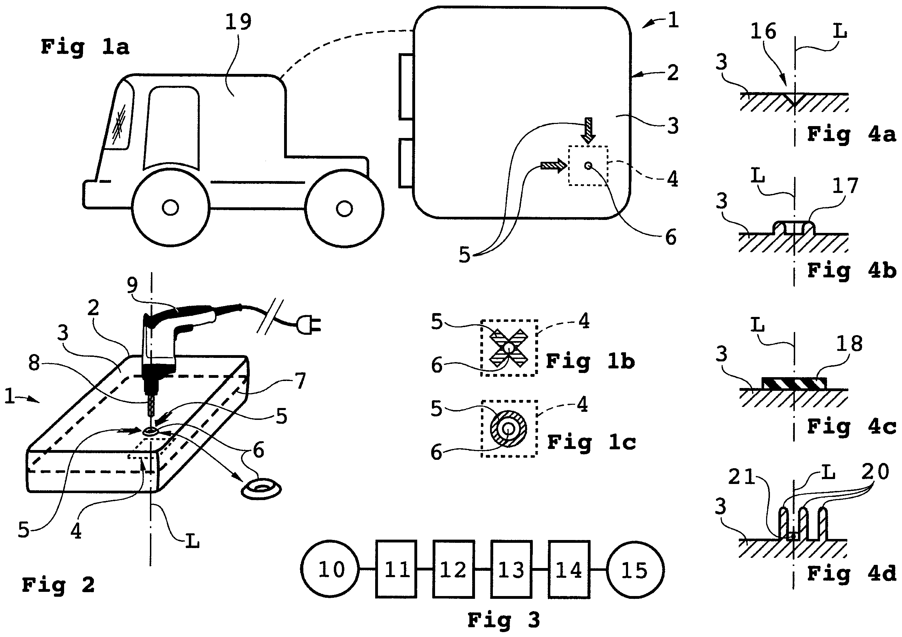

Fig. 1a depicts close to a utility vehicle 19 a control unit 1, and in particular a housing 2 with an upper housing portion 3, which housing contains an undepicted carrier substrate in the form of a circuit card for vehicle control, which circuit card bears a microcontroller which occupies a large number of microcircuits, a storage medium etc. The circuit card has conventional circuits for the energisation etc. of the microcontroller and will not be described in detail here.

Said storage medium in the memory device may for example take the form of any from among ROM (read-only memory), PROM (programmable read-only memory), EPROM (erasable PROM), flash memory, EEPROM (electrically erasable PROM), a hard disc unit etc. and may be situated in the microcontroller or possibly in communication with the calculation unit.

The calculation unit may take for example the form of any suitable kind of processor or microcomputer, e.g. a circuit for digital signal processing (digital signal processor, DSP) or a circuit with a predetermined specific function (application specific integrated circuit, ASIC).

The memory device provides the calculation unit with stored programme code and/or stored data which it needs to enable it to perform conventional calculations etc.

The memory device is represented by broken lines at ref. 4 showing its location in the plane of the control unit on the circuit card in the housing 2.

The embodiment example depicted in Fig. 1a has a position marking 5 in the form of two arrows on the upper housing portion 3. These arrows point to and indicate said location in the plane of the memory device 4 and in particular a guide 6 in the form of a depression in an outer surface of the upper portion 3 of the housing. This depression may be in the form of a small concavity, an indentation or some other kind of recess, created for example by using in the making of the upper housing portion 3 a moulding element provided with a corresponding bulge.

Figs. 1b and 1c depict more schematically first and second alternative configurations of a position marking 5 in the respective form of a cross (in Fig. 1b) with at its centre a guide 6 in the form of a depression, and a circle (in Fig. 1c) with at its centre a guide 6 in the form of a depression.

Further alternative position markings are conceivable, e.g. in the form of dots and lines of various extents and shapes.

Fig. 2 is a perspective view of a control unit 1 with a housing 2 and an upper housing portion 3 which has on its upper surface a guide 6 in the form of an annular ridge at a location, as seen in the drawing, above a memory device 4 which is accommodated on a carrier substrate 7 in the form of a circuit card situated in the housing 2. A perforating tool 8 supported by a handheld drilling machine 9 and directed along the line L by a user (not depicted), normally perpendicular to the housing surface and to the guide 6, is started and is used to drill a hole to a specified depth. This results in the perforating tool 8, usually in the form of a metal drill of helical shape, penetrating both the upper housing portion 3 and the memory device 4, destroying the latter.

Fig. 3 depicts a method sequence according to an embodiment of the invention for making a device according to the invention, in which
step 10 denotes the start of the sequence;
step 11 denotes the identification of a location for a memory device on a carrier substrate;
step 12 denotes modification of a moulding element in order, in an area chosen on the basis of the results of step 10, to provide a housing portion with at least one guide for a perforating tool;
step 13 denotes the housing portion being formed in the moulding element by material being pressed into the respective mould;
step 14 denotes the location of the memory device on the carrier substrate being marked by a position marking being applied to a surface of the completed housing portion;
step 15 denotes conventional assembling of the components and the end of the sequence.

As this sequence represents merely an example, one skilled in the art will appreciate that variations are possible within the scope of the claims set out below. Thus the guide might for example be created by machining of a surface or in some other way indicated by this description.

Fig. 4a depicts a guide 16 in the form of a depression appropriate to directing and guiding a perforating tool along the line L with a view to drilling through the wall of the upper housing portion 3 and continuing through the memory device 4.

Fig. 4b depicts an alternative embodiment in which a guide 17 in the form of an annular ridge surrounds said line L. This guide 17 in the form of an annular ridge may also serve as the position marking.

Fig. 4c depicts a further alternative embodiment of a guide according to the invention, in the form of a layer of flexible material, e.g. synthetic foam material, so situated that a perforating tool (e.g. the tool 8 in Fig. 2) pressed onto it will be prevented from straying sideways. The tool will instead by guided so that drilling reliably takes place along the line L through the wall of the upper portion 3 and continue through the memory device 4. The layer/guide 18 may bear position marking(s) in the form of one or more arrows, a circle etc.

Fig. 4d depicts an alternative embodiment of a guide according to the invention, whereby housings for control units of this kind are typically provided with cooling flanges 20 to guide a perforating tool. This is only possible if the cooling flanges are situated in a way appropriate to the purpose. To this end, transverse ridge portions adjacent to parallel cooling flanges are provided at a suitable distance from one another, typically corresponding to the distance between the cooling flanges, for the delineation of a directing space intended to guide the perforating tool along the line L as above. Fig. 4d shows a ridge portion 21.

The invention may be modified within the scope of the claims and it is for example possible for both a position marking and guides to be situated on surfaces of the control unit's housing which are suitable for the purpose. Thus both upper side, lower side and side edges may be suitable locations for both position markings and guides.

To facilitate perforation perpendicular to a surface of the housing, the latter may partially be provided, in the area where the perforation is to take place, with reflecting material which provides an operator with an indication that the tool is pointing in the intended direction.

## Claims

1. A device pertaining to a control unit for a motor vehicle, comprising a housing (2) for a carrier substrate (7) on which a memory device (4) is situated, **characterised**
- **in that** the housing (2) has an externally visible position marking (5) which indicates a location for the memory device (4) within the housing, and
- that in the area of the position marking (5) the housing is provided with at least one guide (6, 16, 17, 18) for a perforating tool (8),
such that operation of the perforating tool (8) when placed according to the position marking (5) and guided by said at least one guide (8) is appropriate to rendering the memory device (4) unusable.

2. A device according to claim 1, **characterised in that** said position marking (5) takes the form of one or more of the following: colour marking(s) on a surface of the housing, surface structure marking(s) on a surface of the housing, depression(s) in a surface of the housing, elevation(s) on a surface of the housing.

3. A device according to claim 2, **characterised in that** said position marking (5) takes the form of any of the following: at least one arrow, an enclosing marking, a cross.

4. A device according to any one of claims 1 - 3, **characterised in that** said at least one guide (6, 16, 17, 18) takes the form of one or more of the following: a depression (6, 16) in a surface of the housing, one or more guiding elevations (17) on a surface of the housing, a layer (18) of flexible material attached to a surface of the housing.

5. A device according to any one of claims 1 - 4, **characterised in that** said guide is situated between adjacent flange protrusions on the housing (2).

6. A device according to any one of claims 1 - 5, **characterised in that** said position marking (5) and said guides (6, 16, 17, 18) are co-located.

7. A device according to any one of claims 1 - 6, **characterised in that** the housing (2) is made of at least one of the following materials: a plastic material, a composite material comprising plastic, a metal, a metal alloy.

8. A control unit for a motor vehicle comprising a carrier substrate (7) on which a memory device (4) is situated, **characterised in that** the control unit comprises a device according to any one of claims 1 - 7.

9. A method for making a device pertaining to a control unit for a motor vehicle, which control unit comprises a housing (2) for a carrier substrate (7) on which a memory device (4) is situated, **characterised**
- **in that** a location for the memory device (4) on the carrier substrate is indicated by a position marking (5) situated on a surface of the housing, and
- that in the area of the position marking (5) the housing is provided with at least one guide (6, 16, 17, 18) for a perforating tool such that operation of the perforating tool (8) when placed according to the position marking (5) and guided by said at least one guide (8) is appropriate to rendering the memory device (4) unusable.

10. A method according to claim 9, **characterised in that** the position marking (5) takes the form of one or more of the following: colour marking(s) on a surface of the housing, surface structure marking(s) on a surface of the housing, depression(s) in a surface of the housing, elevation(s) on a surface of the housing.

11. A method according to claim 9 or 10, **characterised in that** the position marking (5) and/or said at least one guide (6, 16, 17) are created by a modification in a housing-forming component.

## Patentansprüche

1. Vorrichtung, die eine Steuereinheit für ein Kraftfahrzeug betrifft, umfassend ein Gehäuse (2) für ein Trägersubstrat (7), auf dem eine Speichervorrichtung (4) angeordnet ist, **dadurch gekennzeichnet, dass**
- das Gehäuse (2) eine äußerlich sichtbare Positionsmarkierung (5) umfasst, die die Position der Speichervorrichtung (4) innerhalb des Gehäuses anzeigt, und
- das Gehäuse im Bereich der Positionsmarkierung (5) mindestens einen Anhaltspunkt (6, 16, 17, 18) für eine Bohrungsvorrichtung (8) umfasst,
sodass das Betreiben der Bohrungsvorrichtung (8) geeignet ist, die Speichervorrichtung (4) unbrauchbar zu machen, wenn sie entsprechend der Positionsmarkierung (5) angeordnet ist und durch den mindestens einen Anhaltspunkt (6, 16, 17, 18) geleitet wird.

2. Vorrichtung nach Anspruch 1, **dadurch gekennzeichnet, dass** die Positionsmarkierung (5) eine oder mehrere der folgenden Formen hat: Farbmarkierung(en) auf einer Oberfläche des Gehäuses, Oberflächenstrukturmarkierung(en) auf einer Oberfläche des Gehäuses, Vertiefung(en) auf einer Oberfläche des Gehäuses, Erhebung(en) auf einer Oberfläche des Gehäuses.

3. Vorrichtung nach Anspruch 2, **dadurch gekennzeichnet, dass** die Positionsmarkierung (5) eine der folgenden Formen hat: mindestens einen Pfeil, eine umschließenden Markierung, ein Kreuz.

4. Vorrichtung nach einem der Ansprüche 1 - 3, **dadurch gekennzeichnet, dass** mindestens ein Anhaltspunkt (6, 16, 17, 18) eine oder mehrere der folgenden Formen hat: eine Vertiefung (6, 16) in einer Oberfläche des Gehäuses, eine oder mehrere richtungsweisende Erhebungen (17) auf einer Oberfläche des Gehäuses, eine Schicht (18) eines flexiblen Materials, das auf einer Oberfläche des Gehäuses angebracht ist.

5. Vorrichtung nach einem der Ansprüche 1 - 4, **dadurch gekennzeichnet, dass** der Anhaltspunkt zwischen benachbarten Flanschvorsprüngen an dem Gehäuse (2) angeordnet ist.

6. Vorrichtung nach einem der Ansprüche 1 - 5, **dadurch gekennzeichnet, dass** die Positionsmarkierung (5) und der Anhaltspunkt (6, 16, 17, 18) benachbart positioniert sind.

7. Vorrichtung nach einem der Ansprüche 1 - 6, **dadurch gekennzeichnet, dass** das Gehäuse (2) aus mindestens einem der folgenden Materialien besteht: ein Plastikmaterial, ein Verbundmaterial, das Plastik umfasst, ein Metall, eine Metalllegierung.

8. Steuereinheit für ein Kraftfahrzeug, umfassend ein Trägersubstrat (7) auf dem eine Speichervorrichtung (4) angeordnet ist, **dadurch gekennzeichnet, dass** die Speichereinheit eine Vorrichtung nach einem der Ansprüche 1 - 7 umfasst.

9. Verfahren zur Herstellung einer Vorrichtung betreffend eine Steuereinheit für ein Kraftfahrzeug, wobei die Steuereinheit ein Gehäuse (2) für ein Trägersubstrat (7) umfasst, auf dem die Speichervorrichtung (4) angeordnet ist, **dadurch gekennzeichnet, dass**
- ein Ort für die Speichervorrichtung (4) auf dem Trägersubstrat durch eine Positionsmarkierung (5) angezeigt wird, die auf einer Oberfläche des Gehäuses angeordnet ist, und
- das Gehäuse im Bereich der Positionsmarkierung (5) mindestens einen Anhaltspunkt (6, 16, 17, 18) für eine Bohrungsvorrichtung umfasst, sodass das Betreiben der Bohrungsvorrichtung (8) geeignet ist die Speichervorrichtung (4) unbrauchbar zu machen, wenn sie entsprechend der Positionsmarkierung (5) angeordnet ist und durch den mindestens einen Anhaltspunkt (6, 16, 17, 18) geleitet wird.

10. Verfahren nach Anspruch 9, **dadurch gekennzeichnet, dass** die Positionsmarkierung (5) eine oder mehrere der folgenden Formen hat: Farbmarkierung(en) auf einer Oberfläche des Gehäuses, Oberflächenstrukturmarkierung(en) auf einer Oberfläche des Gehäuses, Vertiefung(en) auf einer Oberfläche des Gehäuses, Erhebung(en) auf einer Oberfläche des Gehäuses.

11. Verfahren nach Anspruch 9 oder 10, **dadurch gekennzeichnet, dass** die Positionsmarkierung (5) und/oder der mindestens eine Anhaltspunkt (6, 16, 17) durch eine Modifikation einer Komponente der Gehäuseformung erzeugt werden.

## Revendications

1. Dispositif concernant une unité de commande d'un véhicule motorisé, comprenant un boîtier (2) pour un substrat de support (7) sur lequel est situé un dispositif de mémoire (4), **caractérisé**
- **en ce que** le boîtier (2) a un marquage de position visible à l'extérieur (5) qui indique un emplacement pour le dispositif de mémoire (4) à l'intérieur du boîtier, et
- **en ce que** dans la zone du marquage de position (5), le boîtier est muni d'au moins un guide (6, 16, 17, 18) pour un outil de perforation (8),
de sorte que le fonctionnement de l'outil de perforation (8) lorsqu'il est placé conformément au marquage de position (5) et guidé par ledit au moins un guide (8) est approprié pour rendre le dispositif de mémoire (4) inutilisable.

2. Dispositif selon la revendication 1, **caractérisé en ce que** ledit marquage de position (5) prend la forme d'un ou de plusieurs éléments suivants : marquage(s) de couleur sur une surface du boîtier, marquage(s) de structure de surface sur une surface du boîtier, creux dans une surface du boîtier, relief(s) sur une surface du boîtier.

3. Dispositif selon la revendication 2, **caractérisé en ce que** ledit marquage de position (5) prend la forme de l'un quelconque des éléments suivants : au moins une flèche, un marquage inclusif, une croix.

4. Dispositif selon l'une quelconque des revendications 1 à 3, **caractérisé en ce que** ledit au moins un guide (6, 16, 17, 18) prend la forme d'un ou de plusieurs éléments suivants : un creux (6, 16) dans une surface du boîtier, un ou plusieurs reliefs de guidage (17) sur une surface du boîtier, une couche (18) de matériau souple fixée à une surface du boîtier.

5. Dispositif selon l'une quelconque des revendications 1 à 4, **caractérisé en ce que** ledit guide est situé entre des saillies de bride adjacentes sur le boîtier (2).

6. Dispositif selon l'une quelconque des revendications 1 à 5, **caractérisé en ce que** ledit marquage de position (5) et lesdits guides (6, 16, 17, 18) sont situés au même endroit.

7. Dispositif selon l'une quelconque des revendications 1 à 6, **caractérisé en ce que** le boîtier (2) est constitué d'au moins l'un des matériaux suivants : une matière plastique, un matériau composite comprenant une matière plastique, un métal, un alliage métallique.

8. Unité de commande pour un véhicule motorisé comprenant un substrat de support (7) sur lequel est situé un dispositif de mémoire (4), **caractérisé en ce que** l'unité de commande comprend un dispositif selon l'une quelconque des revendications 1 à 7.

9. Procédé de fabrication d'un dispositif concernant une unité de commande pour un véhicule motorisé, laquelle unité de commande comprend un boîtier (2) pour un substrat de support (7) sur lequel est situé un dispositif de mémoire (4), **caractérisé**
- **en ce qu'**un emplacement pour le dispositif de mémoire (4) sur le substrat de support est indiqué par un marquage de position (5) situé sur une surface du boîtier, et
- **en ce que** dans la zone du marquage de position (5), le boîtier est muni d'au moins un guide (6, 16, 17, 18) pour un outil de perforation de sorte que le fonctionnement de l'outil de perforation (8) lorsque placé conformément au marquage de position (5) et guidé par ledit au moins un guide (8) est approprié pour rendre le dispositif de mémoire (4) inutilisable.

10. Procédé selon la revendication 9, **caractérisé en ce que** le marquage de position (5) prend la forme d'un ou plusieurs éléments suivants : marquage(s) de couleur sur une surface du boîtier, marquage(s) de structure de surface sur une surface du boîtier, creux dans une surface du boîtier, relief(s) sur une surface du boîtier.

11. Procédé selon la revendication 9 ou 10, **caractérisé en ce que** le marquage de position (5) et/ou ledit au moins un guide (6, 16, 17) sont créés par une modification d'un composant formant boîtier.
